# EUROPÄISCHE PATENTSCHRIFT

(11) **EP 3 350 610 B1**
(45) Veröffentlichungstag und Bekanntmachung des Hinweises auf die Patenterteilung: **15.05.2019**
(21) Anmeldenummer: 16765964.8
(22) Anmeldetag: 13.09.2016
(51) Int. Cl.: G01R 33/34, G01R 33/30, G01R 33/345

(54) **PROBENKOPF FÜR DIE KERNMAGNETISCHE RESONANZSPEKTROSKOPIE**
SAMPLE HEAD FOR NUCLEAR MAGNETIC RESONANCE SPECTROSCOPY
SONDE POUR LA SPECTROSCOPIE PAR RÉSONANCE MAGNÉTIQUE NUCLÉAIRE

(30) Priorität: 14.09.2015 DE 102015115440
(43) Veröffentlichungstag der Anmeldung: 25.07.2018
(73) Patentinhaber: Leibniz - Institut Für Analytische Wissenschaften, 44139 Dortmund (DE)
(72) Erfinder: TELFAH, Ahmad, 44137 Dortmund (DE); HERGENRÖDER, Roland, 44229 Dortmund (DE); LAMBERT, Jörg, 48308 Senden (DE); GOGIASHVILI, Mikheil, 48147 Münster (DE)
(74) Vertreter: Meinke, Jochen
(86) Internationale Anmeldenummer: PCT/EP2016/071535
(87) Internationale Veröffentlichungsnummer: WO 2017/046074

(56) Entgegenhaltungen:
- DE-B3-102014 107 296
- US-A- 5 594 342
- US-B2- 7 560 927
- SEEBER D A ET AL: "Triaxial magnetic field gradient system for microcoil magnetic resonance imaging", REVIEW OF SCIENTIFIC INSTRUMENTS, AIP, MELVILLE, NY, US, Bd. 71, Nr. 11, 1. November 2000 (2000-11-01), Seiten 4263-4272, XP012037841, ISSN: 0034-6748, DOI: 10.1063/1.1313800

## Beschreibung

Die Erfindung betrifft einen Probenkopf für die kernmagnetische Resonanzspektroskopie mit einer Leiterplatte aus einem dielektrischen Material, welche eine Mikrostreifenleiterstruktur trägt, wobei die Mikrostreifenleiterstruktur einen Mikrostreifenleiter mit einer Querschnittsverringerung zur Erzeugung und Detektion eines Radiofrequenzfeldes aufweist.

Probenköpfe für die kernmagnetische Resonanzspektroskopie, die für kleine Probenmengen geeignet sind, werden hauptsächlich mit Solenoid-Spulen aufgebaut. Diese Spulen haben den Nachteil, dass man keine planaren Probenanordnungen, wie z.B. Mikrofluidikchips, als Proben verwenden kann.

Aus US 7 560 927 B2 ist ein Probenkopf mit den Merkmalen des Oberbegriffes des Patentanspruches 1 bekannt. Dieser Probenkopf auf Mikrostreifenleiterbasis weist eine Leiterplatte auf, welche eine Mikrostreifenleiterstruktur mit einem Mikrostreifenleiter trägt, wobei der Mikrostreifenleiter eine Querschnittsverringerung zur Erzeugung und Detektion eines Radiofrequenzfeldes aufweist, der unterschiedlich gestaltet sein kann. Dieser bekannte Probenkopf ist geeignet, um Messungen an planaren Proben, wie Mikrofluidikchips und damit auch für kleine Probenmengen zu ermöglichen. Dabei ist die Querschnittsverringerung auf die zu detektierende Kernsorte abgestimmt, so dass man mit einem solchen Probenkopf an massen- und volumenbegrenzten Proben Messungen an einem Kern durchführen kann.

Es besteht das Bedürfnis, Kernresonanzspektren als Funktion des Ortes (sogenannte ortsaufgelöste Kernresonanzspektroskopie) für massen- und volumenbegrenzte Proben messen zu können. Dadurch sollen die räumliche Verteilung und die Konzentrationen von organischen Molekülen in der Probe gemessen werden können, insbesondere im Hinblick auf Messungen von Metaboliten-Konzentrationen und -verteilungen an Zellkulturmodellen.

Aus SEEBER D A et al: "Triaxial magnetic field gradient system for microcoil magnetic resonance imaging", REVIEW OF SCIENTIFIC INSTRUMENTS, AIP, MEL-VILLE, NY, US, Bd. 71, Nr. 11, 1. November 2000 (2000-11-01), Seiten 4263-4272, XP012037841, ISSN: 0034-6748, DOI: 10.1063/1.1313800 ist eine Einrichtung zur ortsaufgelösten MR-Spektroskopie an kleinen Proben bekannt, wobei für die Erzeugung magnetischer Gradientenfelder separate Gradientenspulen verwendet werden.

Aufgabe der Erfindung ist es, einen Probenkopf auf Mikrostreifenleiterbasis der eingangs bezeichneten Art so weiter zu entwickeln, dass er dazu geeignet ist, ortsaufgelöste Kernresonanzspektroskopie für massen- und volumenbegrenzte Proben zu ermöglichen.

Diese Aufgabe wird bei einem Probenkopf der eingangs bezeichneten Art erfindungsgemäß mit den kennzeichnenden Merkmalen des Patentanspruchs 1 gelöst.

Erfindungsgemäß wird somit ein Probenkopf zur Erzeugung von Radiofrequenzpulsen mit einem Feldgradienten bereit gestellt, bei dem die Querschnittsverringerung eine dreiecksförmige Einschnürung ist, welche zu einer linearen Variation der Stromdichte und damit des korrespondierenden Radiofrequenzfeldes als Funktion des Ortes führt. Es wird somit ein Mikrostreifenleiterprobenkopf für die Kernresonanzspektroskopie zur Verfügung gestellt, der Feldgradientenpulse erzeugen kann und somit eine ortsaufgelöste Kernresonanzspektroskopie für massen- und volumenbegrenzte Proben ermöglicht. Diese Messungen liefern wertvolle Hinweise zur Verteilung und Konzentration von organischen Molekülen in der Probe und Gradienten des Radiofrequenzfeldes haben gegenüber Gradienten des äußeren Magnetfeldes den Vorteil, dass sie keine mechanischen Kräfte auf das Probenmaterial ausüben, keine Wirbelströme erzeugen und keine kostspieligen Gradientenverstärker zu ihrer Ansteuerung benötigen. Der Probenkopf ist somit für die Verwendung in einem Hochauflösungsspektrometer geeignet.

Spektroskopische Messungen mit einem derartigen Probenkopf haben gezeigt, dass das Radiofrequenzfeld linear mit dem Ort variiert. Die dreiecksförmige Einschnürung kann darüber hinaus auch als Detektor dienen.

In bevorzugter Ausgestaltung ist vorgesehen, dass die Einschnürung der Mikrostreifenleiterstruktur symmetrisch zu ihrer Längsachse ausgebildet ist, d.h. die dreiecksförmige Einschnürung bildet annähernd ein gleichschenkeliges Dreieck.

In weiterer bevorzugter Ausgestaltung ist vorgesehen, dass auf der der Mikrostreifenleiterstruktur abgewandten Rückseite der Leiterplatte eine zweite Mikrostreifenleiterstruktur mit einer zweiten Querschnittsverringerung vorgesehen ist, wobei die zweite Querschnittsverringerung als rechteckförmige Aussparung im Mikrostreifenleiter der Mikrostreifenleiterstruktur ausgebildet ist. Dabei weist die rechteckförmige Aussparung bevorzugt eine Länge auf, die der Länge der dreiecksförmigen Querschnittsverringerung entspricht, d.h. exakt an diese angepasst ist. Durch diese zweite Mikrostreifenleiterstruktur lassen sich homogene Radiofrequenzimpulse erzeugen.

Da die Radiofrequenzfeldgradienten von einem elektrischen Netzwerk erzeugt werden, das perfekt abgestimmt ist, sind die Anstiegs- und Abfallzeiten der Gradienten sehr klein. Außerdem treten keine Wirbelströme auf. Die Homogenität des äußeren Magnetfeldes wird von einem Radiofrequenzfeldgradienten nicht beeinflusst, d.h. es ist einfacher, hoch aufgelöste Kernresonanzspektren zu erhalten. Aufgrund der planaren Geometrie des Probenkopfes können auch Mikrofluidikchips als Proben verwendet werden.

In weiterer bevorzugter Ausgestaltung ist vorgesehen, dass die Mikrostreifenleiterstruktur und auch die zweite Mikrostreifenleiterstruktur aus Kupfer, Gold oder Platin besteht.

Die Erfindung ist nachstehend anhand der Zeichnung beispielhaft näher erläutert. Diese zeigt in
- Fig. 1: in perspektivischer Darstellung einen Probenkopf mit eingesetzter Leiterplatte,
- Fig. 2: eine Ansicht auf die Vorderseite der Leiterplatte mit Mikrostreifenleiterstruktur,
- Fig. 3: ein vergrößertes Detail der Mikrostreifenleiterstruktur mit Querschnittsverringerung,
- Fig. 4: ein vergrößertes Detail der Fig. 3, das die dreiecksförmige Einschnürung zeigt,
- Fig. 5: die Rückseite der Leiterplatte nach Fig. 2 mit zweiter Mikrostreifenleiterstruktur,
- Fig. 6: ein vergrößertes Detail der Fig. 5 und
- Fig. 7: ein vergrößertes Detail der Fig. 6 mit rechteckförmiger Aussparung.

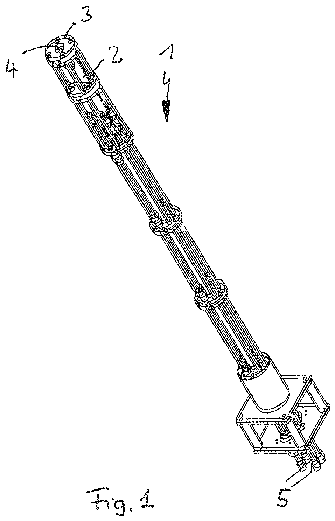

Ein Probenkopf für die kernmagnetische Resonanzspektroskopie ist in Fig. 1 allgemein mit 1 bezeichnet. Der Probenkopf 1 ist im Einzelnen von seinem Gesamtaufbau her so gestaltet, wie er in eine entsprechende Aufnahmebohrung eines nicht dargestellten NMR-Magneten eingeführt wird. In diesen Probenkopf 1 ist im Bereich seiner Spitze eine Leiterplatte 2 auswechselbar eingesetzt, und zwar in einer entsprechenden Aufnahme, die endseitig mit einer Platte 3 verschließbar ist. Diese Platte 3 weist beim Ausführungsbeispiel in der Mitte eine Öffnung 4 auf, am anderen Ende des Probenkopfes 1 sind Abstimmknöpfe 5 angedeutet.

Wesentlich für die erfindungsgemäße Ausgestaltung des Probenkopfes 1 ist deren Leiterplatte 2. Die Leiterplatte 2 selbst besteht aus einem dielektrischen Material, z.B. aus glasfaserverstärktem PTFE oder glasfaserverstärktem Epoxidharz. Sie ist beim Ausführungsbeispiel quaderförmig ausgestaltet und weist eine Breite in der Größenordnung von 30 mm, eine Länge in der Größenordnung von 100 bis 120 mm und eine Dicke in der Größenordnung von 2 bis 4 mm auf.

Wesentlich für den Aufbau der Leiterplatte 2 ist, dass die Leiterplatte 2 wenigstens auf ihrer Vorderseite 2a eine speziell gestaltete Mikrostreifenleiterstruktur aufweist. Diese Mikrostreifenleiterstruktur umfasst einen Mikrostreifenleiter 6 mit einer speziell gestalteten Querschnittsverringerung. Diese Querschnittsverringerung ist erfindungsgemäß als dreiecksförmige Einschnürung 7 ausgebildet, welche eine Länge L und eine entlang ihrer Länge L abnehmende Breite aufweist, die Maximalbreite ist mit B1 und die Minimalbreite mit B2 bezeichnet. Dabei ist die dreiecksförmige Einschnürung 7 symmetrisch zu ihrer Längsachse ausgebildet, d.h. sie bildet annähernd ein gleichschenkeliges Dreieck. Die Länge L beträgt etwa 1,6 mm und die Breite B1 etwa 0,42 mm sowie die Breite B2 etwa 0,035 mm.

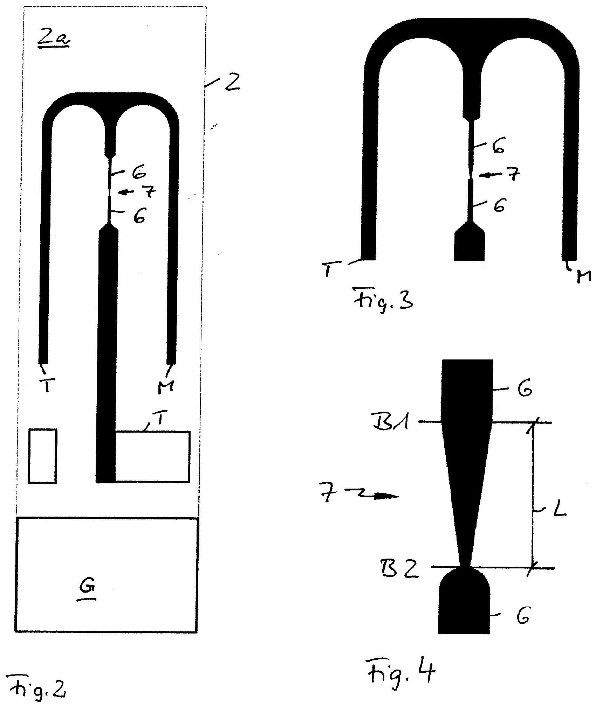

In den Figuren 2 und 3 ist jeweils der Erdungsanschluss für die Mikrostreifenleiterstruktur mit G bezeichnet, Anschlüsse für einen Tune-Kondensator sind mit T und Anschlüsse für einen Match-Kondensator sind mit M bezeichnet.

Aufgrund dieser dreiecksförmigen Einschnürung 7 als Querschnittsverringerung kann der Probenkopf 1 Feldgradientenpulse erzeugen, wodurch die ortsaufgelöste Kernresonanzspektroskopie für massen- und volumenbegrenzte Proben ermöglicht wird.

Bevorzugt weist auch die Rückseite 2b der Leiterplatte 2 eine Mikrostreifenleiterstruktur, nämlich eine zweite Mikrostreifenleiterstruktur mit einem zweiten Mikrostreifenleiter 8 auf. Dieser Mikrostreifenleiter 8 ist mit einer zweiten Querschnittsverringerung versehen, die als rechteckförmige Aussparung 9 im Mikrostreifenleiter 8 der zweiten Mikrostreifenleiterstruktur ausgebildet ist. Diese rechteckförmige Aussparung 9 ist an die dreiecksförmige Einschnürung 7 angepasst, denn die Länge L' dieser Aussparung 9 entspricht der Länge L der dreiecksförmigen Einschnürung 7.

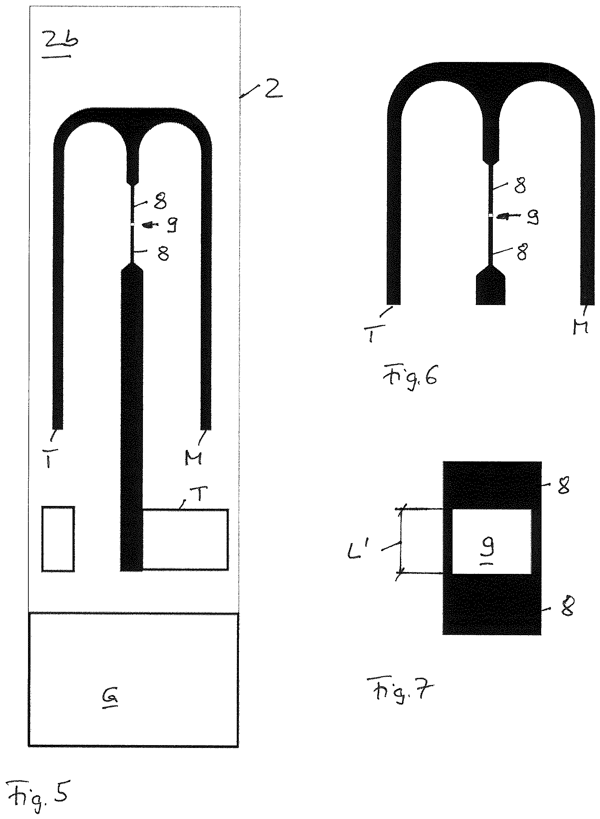

Auch in den Fig. 5 und 6 sind die Anschlüsse der Mikrostreifenleiterstruktur (Erdungsanschluss G, Anschlüsse für einen Time-Kondensator T und Anschlüsse für einen Match-Kondensator M) dargestellt.

Die jeweiligen Mikrostreifenleiterstrukturen bestehen aus einem geeigneten Metall, z.B. Kupfer, Gold oder Platin und sind vorzugsweise auf die Leiterplatte 2 aufgeätzt.

Ein derartiger vorbeschriebener Probenkopf 1 kommt ohne teure Gradientenverstärker aus und verwendet nur die ohnehin vorhandene Hardware eines kommerziellen Kernresonanzspektrometers. Die Messungen sind völlig frei von mechanischen Störungen, so dass mikroskopische Bewegungen der Untersuchungsobjekte ausgeschlossen werden können. Bei der Auswahl der Proben ist man nicht auf Messungen an Röhrchen eingeschränkt, sondern man kann auch planare Proben, wie z.B. Mikrofluidikchips, einsetzen. Die Homogenität des äußeren Magnetfeldes wird durch das Messverfahren nicht gestört, da keine Gradienten des statischen Magnetfeldes angelegt werden müssen, um eine Ortsauflösung zu erzielen. Hochauflösende Kernresonanzspektren sind also leicht zugänglich. Die Ortsauflösung der Technik kann jedoch wegen der zu verwendeten Nutationstechnik nicht wesentlich unter 20 µm betragen, da andernfalls die erhaltenen Spektren nicht mehr zu korrigierende Phasenfehler enthalten.

Der Probenkopf 1 ermöglicht neuartige ortsaufgelöste Metabolismusstudien an sehr geringen Probenmengen mit der kernmagnetischen Resonanzspektroskopie auch an Mikrofluidikchips. So ist der Probenkopf 1 sehr gut für die Messung der räumlichen Verteilung von Metaboliten in Sphäroiden geeignet, die als dreidimensionales Modell für Tumore oder in der pharmakologischen/toxikologischen Forschung Einsatz finden. Außerdem kann der Probenkopf 1 zur nichtinvasiven Charakterisierung von Prozessen eingesetzt werden, die an Flüssiggrenzflächen ablaufen.

### Bezugszeichenliste:

- 1: Probenkopf
- 2: Leiterplatte
- 2a: Vorderseite
- 2b: Rückseite
- 3: Platte
- 4: Öffnung
- 5: Abstimmknöpfe
- 6: Mikrostreifenleiter
- 7: dreiecksförmige Einschnürung
- 8: Mikrostreifenleiter
- 9: rechteckförmige Aussparung

- B1: maximale Breite der Einschnürung
- B2: minimale Breite der Einschnürung
- G: Erdungsanschluss
- L: Länge der Einschnürung
- L': Länge der Aussparung
- M: Anschluss Match Kondensator
- T: Anschluss-Tune-Kondensator

## Patentansprüche

1. Probenkopf für die kernmagnetische Resonanzspektroskopie mit einer Leiterplatte aus einem dielektrischen Material, welche eine Mikrostreifenleiterstruktur trägt, wobei die Mikrostreifenleiterstruktur einen Mikrostreifenleiter mit einer Querschnittsverringerung zur Erzeugung und Detektion eines Radiofrequenzfeldes aufweist,
**dadurch gekennzeichnet,**
**dass** die Querschnittsverringerung der Mikrostreifenleiterstruktur als dreiecksförmige Einschnürung (7) ausgebildet ist, derart, dass die Breite der Einschnürung über ihrer Länge abnimmt, wobei die dreiecksförmige Einschnürung (7) zu einer linearen Variation der Stromdichte und damit des korrespondierenden, vom Probenkopf erzeugten Radiofrequenzfeldes führt, um Feldgradientenpulse für eine ortsaufgelöste Kernresonanzspektroskopie für massen- und volumenbegrenzte Proben zu erzeugen.

2. Probenkopf nach Anspruch 1,
**dadurch gekennzeichnet,**
**dass** die Einschnürung (7) der Mikrostreifenleiterstruktur symmetrisch zu ihrer Längsachse ausgebildet ist.

3. Probenkopf nach Anspruch 1 oder 2,
**dadurch gekennzeichnet,**
**dass** auf der der Mikrostreifenleiterstruktur abgewandten Rückseite (2b) der Leiterplatte (2) eine zweite Mikrostreifenleiterstruktur mit einer zweiten Querschnittsverringerung vorgesehen ist, wobei die zweite Querschnittsverringerung als rechteckförmige Aussparung (9) im Mikrostreifenleiter (8) der Mikrostreifenleiterstruktur ausgebildet ist.

4. Probenkopf nach Anspruch 3,
**dadurch gekennzeichnet,**
**dass** die rechteckförmige Aussparung (9) eine Länge aufweist, die der Länge der dreiecksförmigen Querschnittsverringerung (7) entspricht.

5. Probenkopf nach einem oder mehreren der Ansprüche 1 bis 4,
**dadurch gekennzeichnet,**
**dass** die Mikrostreifenleiterstruktur aus Kupfer, Gold oder Platin besteht.

6. Probenkopf nach Anspruch 3 oder einem der Ansprüche 4 oder 5, sofern von Anspruch 3 abhängig,
**dadurch gekennzeichnet,**
**dass** die zweite Mikrostreifenleiterstruktur aus Kupfer, Gold oder Platin besteht.

## Claims

1. Sample head for nuclear magnetic resonance spectroscopy having a circuit board made of a dielectric material which bears a microstrip line structure, wherein the microstrip line structure has a microstrip line with a cross-sectional reduction for the generation and detection of a radiofrequency field,
**characterised in**
**that** the cross-section reduction of the microstrip line structure is in the form of a triangular neck (7) such that the breadth of the neck decreases over its length, wherein the triangular neck (7) results in a linear variation of the flow density and thus of the corresponding radio frequency field generated by the sample head, in order to generate field gradient pulses for a spatially resolved nuclear resonance spectroscopy for mass constrained and volume constrained samples.

2. Sample head according to claim 1,
**characterised in**
**that** the neck (7) of the microstrip line structure is formed symmetrically to its longitudinal axis.

3. Sample head according to claim 1 or 2,
**characterised in**
**that** on the back side (2b), facing away from the microstrip line structure, of the circuit board (2) is provided a second microstrip line structure having a second cross-section reduction as a rectangular cut-out (9) in the microstrip line (8) of the microstrip line structure.

4. Sample head according to claim 3,
**characterised in**
**that** the rectangular cut-out (9) has a length which is equal to the length of the triangular cross-section reduction (7).

5. Sample head according to one or more of claims 1 to 4,
**characterised in**
**that** the microstrip line structure is made of copper, gold or platinum.

6. Sample head according to claim 3 or any of claims 4 or 5, insofar as they are dependent on claim 3,
**characterised in**
**that** the second microstrip line structure is made of copper, gold or platinum.

## Revendications

1. Sonde pour la spectroscopie par résonance magnétique nucléaire avec une plaque de conducteur en un matériau diélectrique qui porte une structure de ligne microruban, dans laquelle la structure de ligne microruban comporte une ligne microruban avec une réduction de section transversale afin de produire et détecter un champ de radiofréquence,
**caractérisée en ce**
**que** la réduction de section transversale de la structure de ligne microruban est réalisée comme un étranglement triangulaire (7) de telle sorte que la largeur de l'étranglement diminue sur la longueur de celui-ci, dans laquelle l'étranglement triangulaire (7) conduit à une variation linéaire de la densité de courant et donc du champ de radiofréquence correspondant produit par la sonde afin de produire des impulsions de gradient de champ pour une spectroscopie par résonance nucléaire à résolution spatiale pour des échantillons limités en masse et en volume.

2. Sonde selon la revendication 1,
**caractérisée en ce**
**que** l'étranglement (7) de la structure de ligne microruban est réalisé symétrique par rapport à son axe longitudinal.

3. Sonde selon la revendication 1 ou 2,
**caractérisée en ce**
**qu'**il est prévu sur le côté arrière (2b), éloigné de la structure de ligne microruban, de la plaque de conducteur (2) une deuxième structure de ligne microruban avec une deuxième réduction de section transversale, dans laquelle la deuxième réduction de section transversale est réalisée comme un évidement rectangulaire (9) dans la ligne microruban (8) de la structure de ligne microruban.

4. Sonde selon la revendication 3,
**caractérisée en ce**
**que** l'évidement rectangulaire (9) a une longueur qui correspond à la longueur de la réduction de section transversale triangulaire (7).

5. Sonde selon une ou plusieurs des revendications 1 à 4,
**caractérisée en ce**
**que** la structure de ligne microruban est en cuivre, en or ou en platine.

6. Sonde selon la revendication 3 ou selon l'une quelconque des revendications 4 ou 5 dans la mesure où celle-ci est dépendante de la revendication 3, **caractérisée en ce que** la deuxième structure de ligne microruban est en cuivre, en or ou en platine.
